# EUROPÄISCHE PATENTANMELDUNG

(11) **EP 4 804 430 A1**
(43) Veröffentlichungstag der Anmeldung: **09.09.2026**
(21) Anmeldenummer: 26162186.6
(22) Anmeldetag: 04.03.2026
(51) Int. Cl.: H04B 10/80, H10F 55/20

(54) **OPTOKOPPLER**

(30) Priorität: 06.03.2025 DE 102025108617
(71) Anmelder: Fraunhofer-Gesellschaft zur Förderung der angewandten Forschung e.V., 80686 München (DE)
(72) Erfinder: KIRRBACH, René, 01109 Dresden (DE); SCHNEIDER, Tobias, 01109 Dresden (DE); SCHMIEDER, Kai, 01109 Dresden (DE)
(74) Vertreter: König, Andreas Rudolf

(57) **Zusammenfassung**

Ein Optokoppler umfasst eine erste optische Vorrichtung mit einer strahlformenden Optik, wobei die optische Vorrichtung ausgebildet ist, um ein optisch-faserloses Signal auszusenden und eine galvanisch von der ersten optischen Vorrichtung getrennte zweite optische Vorrichtung, die ausgebildet ist, um das optisch-faserlose Signal zu empfangen und in ein elektrisches Signal zu überführen. Eine Haltestruktur ist ausgebildet, um die erste optische Vorrichtung und die zweite optische Vorrichtung für das Senden und Empfangen des optisch-faserlosen Signals in einer festen Relativposition zueinander zu positionieren.

## Beschreibung

Die vorliegende Erfindung bezieht sich auf einen Optokoppler und auf ein System mit einem solchen Optokoppler. Die vorliegende Erfindung bezieht sich insbesondere auf einen Hochgeschwindigkeits-Optokoppler und darunter solche mit hoher Isolationsspannung.

Schaltkreise mit hoher Bandbreite nutzen heute hochentwickelte Transistortechnologien. Diese Transistoren sind sehr klein, was sehr schnelle Schaltvorgänge ermöglicht. Andererseits ist deren Spannungsfestigkeit stark begrenzt. Soll an hohen Spannungen, wie beispielsweise > 1 kV gemessen werden, ist eine Potentialtrennung durch eine galvanische Trennung obligatorisch. Um Daten über einen vergleichsweise großen Potentialunterschied hinweg übertragen zu können, werden Optokoppler eingesetzt. Neue Anwendungen stellen dabei immer anspruchsvollere Anforderungen an Größe, Datenrate und Isolationsspannung, die gängige Optokoppler nicht oder kaum erfüllen können.

Für übliche Optokoppler ist die Datenrate typischerweise bei 50 Mbps begrenzt, da üblicherweise LEDs innerhalb der Optokoppler eingesetzt werden. Die Isolationsspannung innerhalb des Optokopplers ist durch deren Größe (Abstand Sender-Empfänger) und dem Material dazwischen bestimmt. Allerdings ist ein Durchbruch auch an der Leiterplatte-Oberfläche und/oder Optokoppler-Gehäuseoberfläche möglich und in der Tat deutlich wahrscheinlicher.

Der bekannte technische Stand führt dazu, dass Optokoppler mit hohen Isolationsspannungen von mehr als 1 kV groß und teuer sind. Noch deutlicher wird es, wenn höhere Datenraten benötigt werden. Dann müssen mehrere Optokoppler parallel eingesetzt werden, womit ein hoher Platzbedarf und hohe Kosten einhergehen.

Eine Alternative ist der Einsatz von optischen, fasergekoppelten Transceivern, wobei je ein Transceiver an jedem Ende platziert wird und die Isolationsstrecke mit einer optischen Faser überbrückt wird. Dieser Ansatz hat im Wesentlichen zwei Nachteile: Der Aufbau ist groß, da ganze Transceiver-Module benötigt werden und ist gleichzeitig kostenintensiv.

Wünschenswert wäre demnach eine Möglichkeit, mit hohen Datenraten auch bei hohen Isolationsspannungen eine zuverlässige Datenübertragung zu ermöglichen.

Eine Aufgabe der vorliegenden Erfindung besteht deshalb darin, einen Optokoppler bereitzustellen, der es ermöglicht, zuverlässig und mit hohen Datenraten Informationen auch bei hohen Isolationsspannungen zu übertragen.

Diese Aufgabe wird durch den Gegenstand der unabhängigen Patentansprüche gelöst.

Ein Kerngedanke der vorliegenden Erfindung besteht darin, erkannt zu haben, dass die Verwendung gegebenenfalls unidirektional betriebener optischer Transceiver zur Übertragung optisch-faserloser Signale die Möglichkeit bietet, die oben genannten Nachteile zu überwinden und zuverlässig hohe Datenraten auch bei hohen Isolationsspannungen von mehreren Kilovolt oder mehreren Zehn Kilovolt oder noch mehr zu übertragen.

Gemäß einem Ausführungsbeispiel wird ein Optokoppler bereitgestellt, der eine erste optische Vorrichtung mit einer strahlformenden Optik aufweist, die ausgebildet ist, um ein optisch-faserloses Signal auszusenden. Ferner ist eine galvanisch von der ersten optischen Vorrichtung getrennte zweite optische Vorrichtung angeordnet, die ausgebildet ist, um das optisch-faserlose Signal zu empfangen und in ein elektrisches Signal zu überführen. Eine Haltestruktur ist ausgebildet, um die erste optische Vorrichtung und die zweite optische Vorrichtung für das Senden und Empfangen des optisch-faserlosen Signals in einer festen Relativposition zueinander zu positionieren.

Gemäß einem Ausführungsbeispiel weist eine optische Übertragungsstrecke zwischen der ersten optischen Vorrichtung und der zweiten optischen Vorrichtung eine Länge von zumindest 5 mm auf. Damit können bereits Isolationsstärken von mehr als 1 kV erhalten werden und solche Distanzen sind mit optisch-faserlosen Signalen problemlos übertragbar. Die Länge der Übertragungsstecke kann durchaus auch weniger als 5mm oder deutlich mehr als 5mm, bspw. mehrere Zehn Millimeter betragen.

Gemäß einem Ausführungsbeispiel ist das optisch-faserlose Signal ein erstes optisch-faserloses Signal, wobei die zweite optische Vorrichtung ausgebildet ist, um ein zweites optisch-faserloses Signal an die erste optische Vorrichtung zu senden. Dadurch kann eine bidirektionale Kommunikation zum wechselseitigen Datenaustausch ermöglicht werden. Es ist dabei sowohl möglich, dass die Kommunikation für den Halbduplex- wie auch für den Vollduplexmodus eingerichtet ist.

Gemäß einem Ausführungsbeispiel umfasst der Optokoppler einen elektrischen Isolationsbereich zwischen der ersten optischen Vorrichtung und der zweiten optischen Vorrichtung, beispielsweise als ein Isolationselement oder eine Aussparung, was die Durchbruchspannung weiter erhöhen kann. Das Isolationselement ist typischerweise durch eine hohe Durchschlagsfestigkeit gekennzeichnet.

Gemäß einem Ausführungsbeispiel umfasst die Haltestruktur eine Leiterplattenstruktur und die erste optische Vorrichtung und die zweite optische Vorrichtung sind an der Leiterplattenstruktur angeordnet. Dies ermöglicht eine präzise Relativpositionierung der Vorrichtungen zueinander und auch die Verschaltung mit weiteren Elementen.

Gemäß einem Ausführungsbeispiel ist die erste optische Vorrichtung an einer Optikmontageseite eines ersten Leiterplattenelements der Leiterplattenstruktur angeordnet und die zweite optische Vorrichtung an einer Optikmontageseite eines räumlich beabstandeten zweiten Leiterplattenelements angeordnet, wobei die Optikmontageseiten einander zugewandt oder abgewandt sind. Dies ermöglicht einen weiteren Freiheitsgrad bei der Auslegung von Datenübertragungssystemen. In anderen Ausführungen weisen die Optikmontageseiten in eine gleiche Richtung, was beispielsweise durch eine Aufteilung der Leiterplattenstruktur in mehrere Teilelemente erhalten werden kann.

Gemäß einem Ausführungsbeispiel umfasst ein Optokoppler ein erstes elektrisches Isolationselement, das an dem ersten Leiterplattenelement angeordnet ist und dem zweiten Leiterplattenelement zugewandt ist und ferner ist ein zweites elektrisches Isolationselement vorgesehen, das an dem zweiten Leiterplattenelement und dem ersten Leiterplattenelement zugewandt angeordnet ist. Dies ermöglicht eine Fertigung der Einzelelemente, beispielsweise eines jeweiligen Leiterplattenelements mit einer daran angeordneten optischen Vorrichtung und einem späteren Kommunikationspartner zugewandten Isolationselement, dahingehend, dass die Einzel-Kommunikationspartner individuell gefertigt und/oder angeordnet werden können.

Gemäß einem Ausführungsbeispiel ist der Optokoppler so gebildet, dass das erste elektrische Isolationselement die erste optische Vorrichtung zumindest teilweise kapselt und/oder das zweite elektrische Isolationselement die zweite optische Vorrichtung zumindest teilweise kapselt. Hierdurch kann ein zusätzlicher Schutz der optischen Vorrichtungen vor elektrischer Spannung einerseits, aber auch vor weiteren Umwelteinflüssen, wie Feuchtigkeit oder Verunreinigung erhalten werden.

Gemäß einem Ausführungsbeispiel umfasst die Leiterplattenstruktur eine Aussparung entlang einer Strecke zwischen der ersten optischen Vorrichtung und der zweiten optischen Vorrichtung, beispielsweise eine Vertiefung oder einen Freiraum beziehungsweise durchgängige Aussparung zwischen den Optikmontageseiten der Leiterplattenstruktur. Eine Ausdehnung senkrecht zu der Strecke zwischen den beiden optischen Vorrichtungen stellt eine Kriechstromwegverlängerung bereit, da aufgrund der Aussparung Kriechströme Umwege um die Aussparung herum zurücklegen müssen, was die Spannungsfestigkeit des Optokopplers weiter erhöht.

Gemäß einem Ausführungsbeispiel umfasst die Haltestruktur ein elektrisch isolierendes Isolationselement, das entlang einer Strecke zwischen der ersten optischen Vorrichtung und der zweiten optischen Vorrichtung zumindest teilweise angeordnet ist. Das Isolationselement kann eine ähnliche Wirkung hinsichtlich elektrischer Kriechströme bereitstellen, wie eine Aussparung, wobei die für das Isolationselement verwendete Materialien eine vergleichsweise höhere Spannungsfestigkeit bereitstellen können.

Gemäß einem Ausführungsbeispiel ist das Isolationselement für einen Wellenlängenbereich des optisch-faserlosen Signals transparent gebildet und in einem Verlauf eines Pfads des optisch-faserlosen Signals angeordnet. Dies ermöglicht eine besonders vorteilhafte Isolierung der beiden optischen Vorrichtungen voneinander und ermöglicht es auch in einer Ausgestaltung, zumindest eine der beiden optischen Vorrichtungen zumindest teilweise mit dem Isolationselement zu kapseln, beispielsweise indem die Vorrichtung eingegossen wird oder als eine Art Gehäuse bedeckt wird.

Gemäß einem Ausführungsbeispiel ist das Isolationselement in einem Kontaktbereich in eine Aussparung der Haltestruktur eingepresst und weist in dem Kontaktbereich Erhebungen oder Vertiefungen, auch genannt Nasen, bezüglich der Haltestruktur auf, die ausgebildet sind, um eine Klemmkraft gegenüber der Haltestruktur bereitzustellen. Dies ermöglicht eine besonders vorteilhafte Fertigung bei gleichzeitig hoher Schutzwirkung des Isolationselements.

Gemäß einem Ausführungsbeispiel umfasst ein Optokoppler eine Kriechstromwegverlängerung, die ausgebildet ist, um eine Weglänge eines Kriechstroms verglichen mit einem direkten Pfad und zwischen der ersten optischen Vorrichtung und der zweiten optischen Vorrichtung zu verlängern, was die Durchschlagsfestigkeit erhöht.

Gemäß einem Ausführungsbeispiel bilden die erste optische Vorrichtung und die zweite optische Vorrichtung ein erstes Übertragerpaar. Der Optokoppler umfasst insgesamt eine Mehrzahl von für einen zeitlich und/oder räumlich parallelen Betrieb eingerichteten Übertragerpaaren, die an der Haltestruktur angeordnet ist. Dies ermöglicht es, die Bandbreite des Optokopplers verglichen mit einem einzigen Übertragerpaar zu erhöhen, wobei die Nachteile aus fasergebundenen Übertragern vermieden werden können.

Gemäß einem Ausführungsbeispiel ist der Optokoppler ausgebildet, um basierend auf voneinander verschiedenen Sensorelementen Sensordaten für voneinander verschiedene Sensorkanäle mit voneinander verschiedenen Übertragerpaaren zu übertragen. Dies ermöglicht eine hohe Flexibilität bei der Auslegung des Optokopplers. Es ist auch denkbar, dass es sich bei den verschiedenen Datenkanälen auch um anderen Signale, wie bspw. Steuersignale handelt oder, dass einige Kanäle Steuer- und andere Sensorsignale enthalten.

Gemäß einem Ausführungsbeispiel ist der Optokoppler für einen Betrieb in einer Optikanordnung eingerichtet, wobei sich die Optikanordnung parallel zu einer Optikebene erstreckt und wobei die erste optische Vorrichtung und die zweite optische Vorrichtung in einer übereinstimmenden Ebene parallel zu der Optikebene angeordnet sind. Beispielsweise sind die optischen Vorrichtungen ausgebildet, um das optisch-faserlose Signal tangential zu einer Leiterplatte oder dergleichen auszutauschen und befinden sich im Wesentlichen in derselben Ebene bezogen auf die Leiterplattenebene. Gemäß einem alternativen Ausführungsbeispiel sind die erste optische Vorrichtung und die zweite optische Vorrichtung in unterschiedlichen Ebenen gegenüberliegend zueinander angeordnet, was einfachere Optiken für die Formung des optisch-faserlosen Signals ermöglichen kann und alternativ oder zusätzlich auch einen geringeren Platzbedarf auf einer Leiterplattenebene ermöglichen kann.

Gemäß einem Ausführungsbeispiel ist ein optischer Transmitter der ersten optischen Vorrichtung und ein optischer Empfänger der zweiten optischen Vorrichtung in einer radialen Anordnung positioniert, was zusätzliche Freiheitsgrade bereitstellt. In einer solchen Ausgestaltung kann der optische Transmitter den optischen Empfänger an der Ausgangsapertur umschließen; oder der optische Empfänger den optischen Transmitter an der Ausgangsapertur umschließen.

Gemäß einem Ausführungsbeispiel ist der Optokoppler als integrierte Vorrichtung gebildet oder Teil eines integrierten Systems, was eine kompakte Bauweise ermöglicht.

Gemäß einem Ausführungsbeispiel ist die erste optische Vorrichtung ausgebildet, um das optisch-faserlose Signal im Wesentlichen parallel zu einer Montageoberfläche auszusenden, an welcher die erste optische Vorrichtung angeordnet ist; oder bei dem die erste optische Vorrichtung ausgebildet ist, um das optisch-faserlose Signal im Wesentlichen senkrecht zu der Montageoberfläche auszusenden, etwa hinsichtlich einer Anordnung nebeneinander oder übereinander.

Gemäß einem Ausführungsbeispiel umfasst ein System einen hierin beschriebenen Optokoppler und eine Datenquelle, die mit der ersten optischen Vorrichtung gekoppelt ist, um vermittels des optisch-faserlosen Signals Daten an die zweite optische Vorrichtung zu senden. Ein Datenempfänger ist ausgebildet, um die Daten von der zweiten optischen Vorrichtung zu empfangen.

Gemäß einem Ausführungsbeispiel umfasst die Datenquelle einen oder mehrere Sensoren, ein feldprogrammierbares Gatterarray, FPGA, und/oder einen funktionsspezifischen integrierten Schaltkreis, ASIC. Dies ermöglicht vorteilhafterweise kleine Optokoppler beziehungsweise kleine Systeme.

Gemäß einem Ausführungsbeispiel ist die Datenquelle mit einer Niederpotentialseite des Systems und der Datenempfänger mit einer Hochpotentialseite des Systems elektrisch gekoppelt. Eine inverse Implementierung ist ohne weiteres möglich, wonach die Datenquelle mit der Hochpotentialseite des Systems und der Datenempfänger mit der Niederpotentialseite des Systems elektrisch gekoppelt ist. Durch den verwendeten Optokoppler kann die Datenübertragung sicher zwischen den beiden Potentialseiten erfolgen. Der Begriff "Potential" bezieht sich hierbei auf das elektrische Potential (Coulomb-Potential).

Gemäß einem Ausführungsbeispiel ist das System als integriertes System gebildet, was eine platzsparende Implementierung ermöglicht.

Weitere vorteilhafte Ausgestaltungen der vorliegenden Erfindung sind der Gegenstand abhängiger Patentansprüche.

Besonders bevorzugte Ausführungsformen der vorliegenden Erfindung werden nachfolgend Bezug nehmend auf die beiliegenden Zeichnungen erläutert. Es zeigen:
- Fig. 1: ein schematisches Blockschaltbild eines Optokopplers gemäß einem Ausführungsbeispiel;
- Fig. 2: eine schematische perspektivische Ansicht eines Systems gemäß einem Ausführungsbeispiel, das einen Optokoppler gemäß einem Ausführungsbeispiel aufweist;
- Fig. 3: eine schematische perspektivische Ansicht eines Systems gemäß einem Ausführungsbeispiel, bei dem der Optokoppler eine Aussparung der Haltestruktur aufweist;
- Fig. 4: eine schematische perspektivische Ansicht eines Systems gemäß einem Ausführungsbeispiel, mit einem Isolationselement zwischen den optische Vorrichtungen des Optokopplers;
- Fig. 5: eine schematische perspektivische Ansicht eines Systems gemäß einem Ausführungsbeispiel, bei dem ein Optokoppler mehrere Übertragerpaare für optisch-faserlose Signale umfasst;
- Fig. 6: ein schematisches Blockschaltbild eines Optokopplers gemäß einem Ausführungsbeispiel, der für eine bidirektionale Kommunikation eingerichtet ist;
- Fig. 7: eine schematische perspektivische Ansicht eines Systems gemäß einem Ausführungsbeispiel, bei dem die optischen Vorrichtungen des Optokopplers an verschiedenen Leiterplattenelementen angeordnet sind;
- Fig. 8: ein schematisches Blockschaltbild eines Systems gemäß einem Ausführungsbeispiel, bei dem die Transceiver des Optokopplers in einer gestapelten Anordnung vorliegen;
- Fig. 9: eine schematische Draufsicht auf ein System gemäß einem Ausführungsbeispiel;
- Fig. 10: schematische Draufsicht auf ein System ähnlich zur Fig. 9, bei dem die Haltestruktur mit zwei getrennten Leiterplatten und jeweiligem Isolator ausgeführt ist; und
- Fig. 11: eine schematische Draufsicht auf ein System gemäß einem Ausführungsbeispiel, bei dem zumindest ein Transceiver von einem Isolationselement gekapselt ist.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgend beschriebene Ausführungsbeispiele werden im Zusammenhang mit einer Vielzahl von Details beschrieben. Ausführungsbeispiele können jedoch auch ohne diese detaillierten Merkmale implementiert werden. Des Weiteren werden Ausführungsbeispiele der Verständlichkeit wegen unter Verwendung von Blockschaltbildern als Ersatz einer Detaildarstellung beschrieben. Ferner können Details und/oder Merkmale einzelner Ausführungsbeispiele ohne Weiteres mit einander kombiniert werden, solange es nicht explizit gegenteilig beschrieben ist.

Nachfolgende Ausführungsbeispiele beziehen sich auf eine optisch-kabellose synonym als optisch-drahtlos und optisch-faserlos bezeichnete Signalübertragung oder Datenübertragung. Diese kann im Rahmen der hierin beschriebenen Ausführungsbeispiele auch als LiFi bzw. Li-Fi (Light Fidelity; Lichtübertragung) bezeichnet werden. Als optisch-kabellose Übertragungen können unter anderem Begriffe wie IrDA (Infrared Data Association) oder OWC (Optical Wireless Communication; optische drahtlose Kommunikation) verstanden werden. Das bedeutet, die Ausdrücke "optisch-drahtlose Datenübertragung", "optisch-kabelloser Datenübertragung", "optisch-faserlose Übertragung" und "LiFi" werden synonym verwendet. Als optisch-faserlose Datenübertragung wird hierbei verstanden, ein elektromagnetisches Signal durch ein freies Übertragungsmedium, beispielsweise Luft oder ein anderes Gas oder ein Fluid, zu übertragen. Hierfür können beispielsweise Wellenlängen in einem ultravioletten (UV) Bereich mit zumindest 100 nm und dem Infrarotbereich, beispielsweise höchstens 1550 nm, verwendet werden, wobei auch andere Wellenlängen möglich sind, die sich von für Funkstandards benutzten Wellenlängen unterscheiden. Eine optisch-kabellose Datenübertragung ist auch von einer fasergebundenen optischen Datenübertragung zu unterscheiden, die beispielsweise mittels Lichtwellenleiter oder Lichtwellenleiterkabel implementiert wird. Die Begriffe Transmitter und Sender werden als Synonyme verwendet. Gleiches gilt für die Begriffe Empfänger und Receiver.

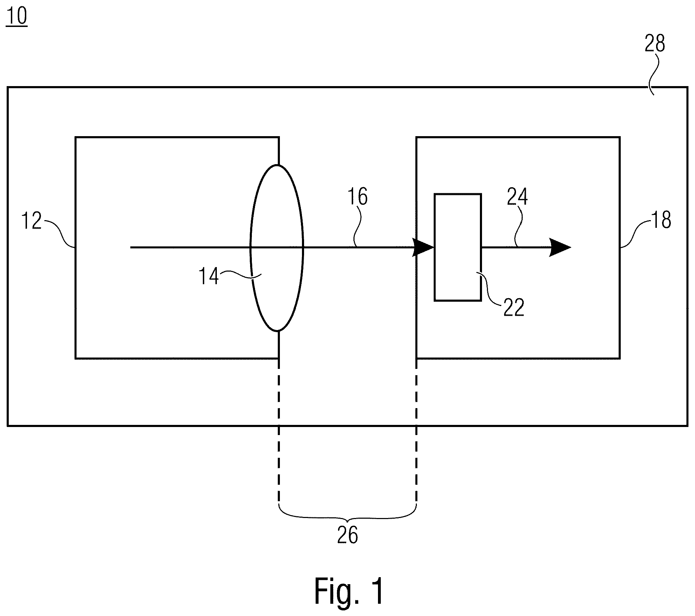

Fig. 1 zeigt ein schematisches Blockschaltbild eines Optokopplers 10 gemäß einem Ausführungsbeispiel. Der Optokoppler 10 umfasst eine erste optische Vorrichtung 12 mit einer strahlformenden Optik 14 und ist ausgebildet, um ein optisch-faserloses Signal 16 auszusenden. Das optisch-faserlose Signal 16 unterscheidet sich unter anderem basierend auf der Strahlformung durch die Optik 14 von einfachen LED oder Laserdioden-Übertragern. Im Weiteren kann auch eine Signalmodulation sowie eine Verstärkerschaltung angeordnet sein, um ein Element zum Aussenden beziehungsweise Erzeugen des optisch-faserlosen Signals 16 anzusteuern. In einer optionalen bidirektionalen Ausgestaltung des Optokopplers für eine bidirektionale Implementierung kann sowohl die erste optische Vorrichtung 12 als auch der Kommunikationspartner, eine zweite optische Vorrichtung, als optischer Transceiver ausgebildet sein, etwa dahingehend, um optisch-faserlose Signale in einem freien Medium zu übertragen.

In einem solchen Fall kann auch die zweite optische Vorrichtung 18 strahlformende Optiken aufweisen, wobei dies optional auch für den Empfangsfall möglich ist. Die zweite optische Vorrichtung 18 umfasst eine Empfängereinrichtung 22, die ausgebildet ist, um basierend auf dem optisch-faserlosen Signal 16 ein elektrisches Signal 24 bereitzustellen, etwa an einer Ausgangsschnittstelle oder für ein Bauelement des Optokopplers. Die Empfängereinrichtung 22 kann beispielsweise einen Fotodetektor wie bspw. eine Fotodiode oder dergleichen umfassen.

Gemäß einem optionalen Ausführungsbeispiel kann eine optische Übertragungsstrecke zwischen den optischen Vorrichtungen 12 und 18 eine Länge 26 von zumindest 5 mm, zumindest 10 mm, zumindest 20 mm oder mehr aufweisen. Damit und basierend auf einem in der Übertragungsstrecke angeordneten Material oder anderer Eigenschaften kann eine Isolationsfestigkeit oder Durchschlagsspannung des Optokopplers zumindest teilweise eingestellt werden.

Der Optokoppler umfasst eine Haltestruktur 28, die ausgebildet ist, um die erste optische Vorrichtung 12 und die zweite optische Vorrichtung 18 für das Senden und Empfangen des optisch-faserlosen Signals 16 in einer festen Relativposition zueinander zu positionieren. Die feste Relativposition kann beispielsweise durch ein Verschrauben oder Löten oder dergleichen erhalten werden und eine während des Betriebs womöglich unveränderliche Relativposition bewirken. Dies schließt die Implementierung von Möglichkeiten zur Justierung oder Kalibrierung nicht aus, wonach beispielweise zur Einstellung des Betriebszustandes Veränderungen in der Relativposition möglich sind.

Die Haltestruktur 28 kann beispielsweise ein nicht notwendigerweise plattenförmiges Substrat oder ein Gestell umfassen, wobei sich beispielsweise im Hinblick auf die Versorgung der Komponenten mit elektrischer Energie Verdrahtungsträger mit einem polymeren Isolierstoff - wie beispielsweise Leiterplattensubstrate - als auch anorganische Träger - beispielsweise auf Keramikbasis - eignen können.

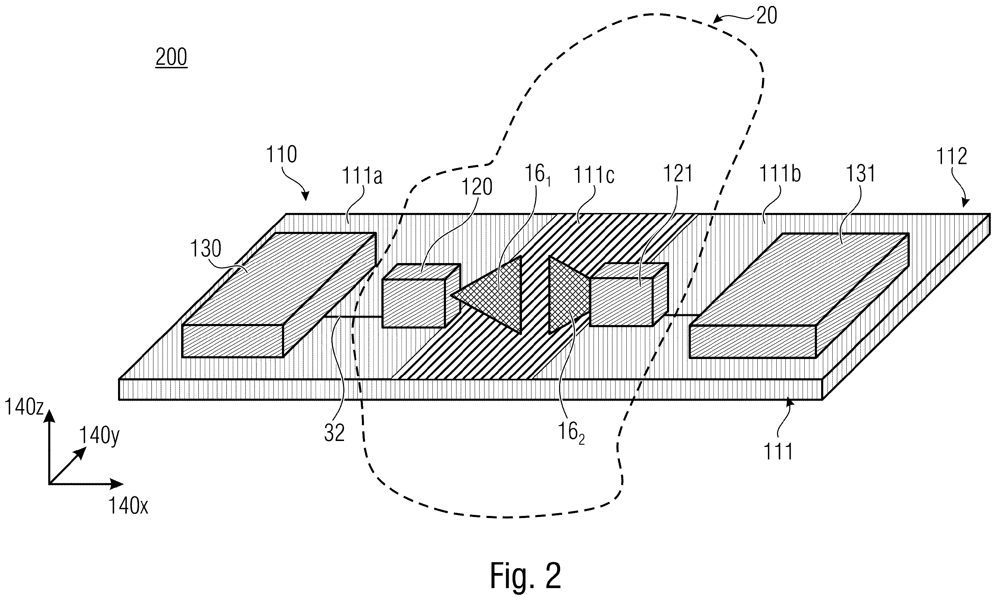

Fig. 2 zeigt eine schematische perspektivische Ansicht eines Optokopplers 20 gemäß einem Ausführungsbeispiel, der mehrere, jeweils optionale aber problemlos miteinander kombinierbare Erweiterungen gegenüber dem Optokoppler 10 aufweist.

So kann der Optokoppler 20 beispielsweise für einen bidirektionalen Informationsaustausch eingerichtet sein und eine hierfür eingesetzte erste optische Vorrichtung 120, die in Übereinstimmung mit der optischen Vorrichtung 12 und/oder 18 sein kann, kann ausgebildet sein, um ein optisch-faserloses Signal 16₁ an eine zweite optische Vorrichtung 121, die in Übereinstimmung mit der optischen Vorrichtung 12 und/oder 18 sein kann, zu senden. Die optische Vorrichtung 121 kann wiederum ausgebildet sein, um ein optisch-faserloses Signal 16₂ an die erste optische Vorrichtung 120 zu senden. Bei Verwendung entsprechender Verfahren zum Vielfachzugriff oder anderer Konzepte zur Signaltrennung kann die Übertragung der Signale 16₁ und 16₂ auch simultan oder gleichzeitig erfolgen, etwa unter Verwendung von unterschiedlichen Wellenlängen. Alternativ oder zusätzlich kann auch ein Halb-Duplex-Verfahren verwendet werden. Als Verfahren zum Vielfachzugriff können bspw. ein Zeitmultiplex, ein Wellenlängenmultiplex, ein etwa durch die Linse des Transceivers erzeugte oder bereitgestellter Raummultiplex sowie weitere Multiplexverfahren und insbesondere auch Kombinationen hieraus angewendet werden.

Der Optokoppler 20 ist als Teil eines Systems 200 dargestellt, das ferner eine Datenquelle 130 sowie einen Datenempfänger 131 aufweist. Es wird darauf hingewiesen, dass insbesondere in Anbetracht der bidirektionalen Kommunikation des Optokopplers 20 die Funktionen der Datenquelle 130 und des Datenempfängers 131 auch problemlos vertauscht werden können und/oder wechselseitig ergänzt werden können, so dass zumindest einer der beiden Blöcke 130 und 131 als Datenquelle und Datenempfänger genutzt werden kann. Auch ist es möglich, dass die Blöcke 130 und 131 sowohl als Datenquelle und Datenempfänger gleichzeitig agieren. Bspw. kann der Block 130 Sensordaten erzeugen und diese als Datenquelle weiterleiten und gleichzeitig auch Steuerdaten von 131 empfangen, was ihn auch zu einem Datenempfänger macht.

Eine Übermittlung von Information zwischen der Datenquelle 130 und der ersten optischen Vorrichtung 120, die beispielsweise in Übereinstimmung mit der ersten optischen Vorrichtung 12 sein kann, kann beispielsweise als elektrisches und/oder optisches oder anders geartetes Signal 32 erfolgen. Das Gleiche gilt für die Übertragung zwischen einer beispielsweise als optische Vorrichtung 12 gebildete zweite optische Vorrichtung 121 und den Datenempfänger 131. Ist beispielsweise der Datenempfänger 131 als Teil des Optokopplers gebildet oder angeordnet, so kann eine Konversion des optisch-faserlosen Signals 16₁ in ein elektrisches Signal auch erst im Bereich des Datenempfängers 131 erfolgen.

Eine Haltestruktur 111, die in Übereinstimmung mit der Haltestruktur 28 sein kann, ist beispielsweise als Leiterplatte ausgeführt und weist möglicherweise aber nicht notwendigerweise drei Bereiche 111a, 111b und 111c auf, wobei die Bereiche 111a und 111b beispielsweise unterschiedlichen Potentialbereichen zugeordnet sind, etwa einem Bereich 110 mit niedrigem elektrischen Potential, und 112, einem Bereich mit vergleichsweise höherem elektrischen Potential, wobei die Potentiale der Bereiche 110 und 112 ohne weiteres durch mehrere kV, mehrere 10 kV oder mehr getrennt sein können. Der Begriff Potential bezieht sich hierbei auf das elektrische Potential (Coulomb-Potential).

Ein Bereich 111c kann als Isolationsbereich genutzt werden, der basierend auf einem Abstand zwischen den optischen Vorrichtungen 120 und 121 und womöglich basierend auf weiteren Komponenten oder Merkmalen derartige Isolationsspannungen bereitstellen kann.

Das System 200 kann ein oder mehrere Sensoren aufweisen oder mit diesen koppelbar sein, die beispielsweise Teil der Datenquelle 130 sein können oder mit dieser koppelbar sein können. Alternativ oder zusätzlich kann die Datenquelle 130 und/oder der Datenempfänger 131 ein feldprogrammierbares Gatterarray (engl.: Field Programmable Gate Array, FPGA) und/oder einen funktionsspezifischen integrierten Schaltkreis (engl.: Application Specific Integrated Circuit, ASIC) umfassen.

Das System 200 kann ohne weiteres auch als integriertes System gebildet sein, was eine kleine Ausfertigung in vorteilhafterweise ermöglicht.

Der Isolationsbereich 111c kann als elektrischer Isolationsbereich zwischen den optischen Vorrichtungen 120 und 121 die elektrische Durchschlagsfestigkeit des Optokopplers 20 zumindest teilweise bereitstellen. Der Isolationsbereich 111c kann ein oder mehrere unterschiedliche Mechanismen zur Bereitstellung der Durchschlagsfestigkeit bereitstellen. So ist beispielsweise der physikalische Abstand ein erstes Mittel zur Bereitstellung der Durchschlagsfestigkeit, bei dessen Erhöhung auch die Durchschlagsfestigkeit steigt. Eine Oberflächenrauheit, beispielsweise durch Rillen oder dergleichen, insbesondere senkrecht zu einer Richtung zwischen den optischen Vorrichtungen 120 und 121 verlaufend, kann die Weglänge, die ein Kriechstrom zurückzulegen hat, bereits vergrößern und die Durchschlagsfestigkeit dadurch erhöhen. In einer Ausgestaltung der vorliegenden Erfindung ist in dem Isolationsbereich 111c deshalb eine Rillenstruktur vorgesehen, um eine Weglänge für den Kriechstrom verglichen mit einem direkten Pfad zwischen den optischen Vorrichtungen 120 und 121 zu verlängern.

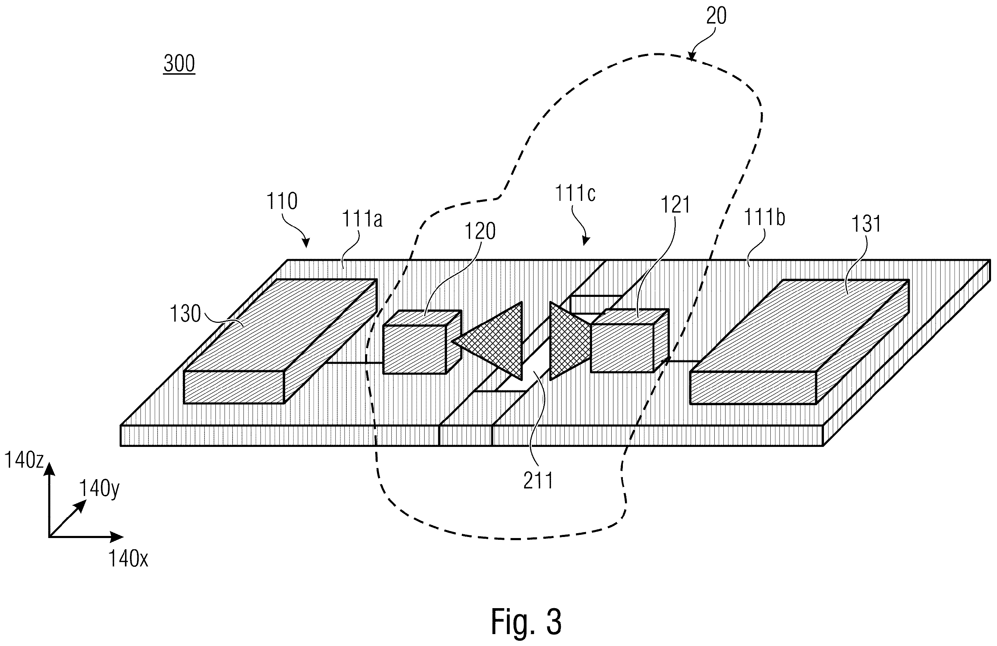

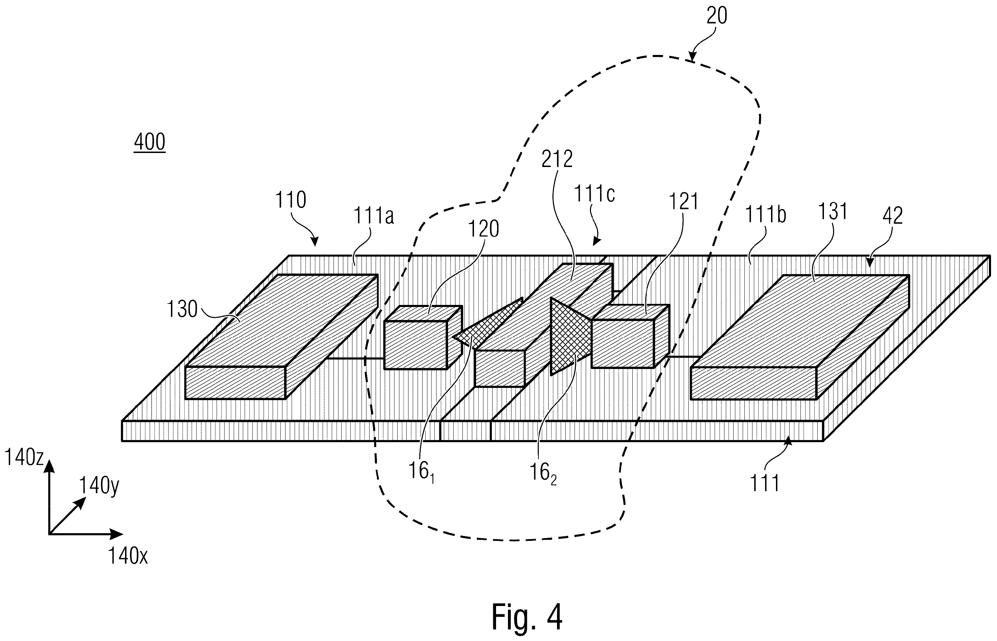

Weitere vorteilhafte Ausgestaltungen können bei der Verwendung einer Leiterplatte als Haltestruktur vorteilhaft implementiert werden, sind aber hierauf nicht angewiesen. So kann in dem Isolationsbereich 111c eine im Zusammenhang mit der Fig. 3 beschriebene Aussparung, etwa eine Vertiefung oder ein Loch, vorgesehen sein und/oder es kann ein Isolationselement vorgesehen sein, wie es beispielsweise anhand der Fig. 4 beschrieben ist.

Anhand der Fig. 2 wird verdeutlicht, dass eine Implementierung der Haltestruktur als Leiterplattenstruktur es ermöglicht, weitere Komponenten, etwa die Datenquelle 130 und/oder den Datenempfänger 131, anzuordnen und diese mit den optischen Vorrichtungen 120/121 zu koppeln. Es ist dabei möglich aber nicht notwendig, dass die Haltestruktur einstückig gebildet ist. Wie es im Zusammenhang mit Ausführungsformen der vorliegenden Erfindung offenbart ist, kann die Haltestruktur, beispielsweise eine Leiterplattenstruktur, auch aus mehreren Einzelelementen gebildet sein, die womöglich relativ zueinander positioniert sind und/oder gedreht zueinander sind.

Fig. 2 zeigt eine Implementierung der vorliegenden Erfindung als einen neuartigen Optokoppler, der aus mindestens zwei optisch-drahtlosen Vorrichtungen, bevorzugt Transceivern, besteht bzw. diese umfasst, welche in manchen Ausführungsformen im Wesentlichen tangential, wie durch die Richtung 140x dargestellt, zur Substratoberfläche, beispielsweise einer Leiterplatte, kommunizieren. Es werden bevorzugt keine optischen Fasern eingesetzt, das heißt, die Übertragung zwischen den beiden optischen Vorrichtungen ist zumindest teilweise frei von einer optischen Faser. Die beiden Transceiver 120, 121 können auf einer Leiterplatte oder auf zwei verschiedenen Leiterplatten oder Substraten platziert werden. Die Distanz zwischen den Transceivern kann die Isolationsspannung zumindest teilweise bestimmen.

Der Isolationsbereich 111c auf der Leiterplatte 111 ist bevorzugt frei von metallischen Leitern. Da sich die Reichweite der Transceiver im Bereich von mehreren Zentimetern und mehr bewegt, können hohe Isolationsspannungen von mehreren kV, mehreren 10 kV oder mehr realisiert werden. Auf diese Weise kann die Leiterplatte der Fig. 2 in einem Bereich 110 mit niedrigerem elektrischen Potential und einem Bereich 112 mit höherem elektrischen Potential getrennt werden, wobei diese Beschreibung wechselseitig austauschbar ist. Die Transceiver können LEDs oder Laserdioden einsetzen, so dass sie Datenraten von mehreren Gbps erreichen können. Das bedeutet, eine Signalerzeugungseinrichtung einer hierin beschriebenen optischen Vorrichtung kann eine solche LED oder Laserdiode umfassen, die ausgebildet ist, um das optisch-faserlose Signal bereitzustellen. Die Transceiver können unidirektional oder bidirektional im Halbduplexmodus oder Vollduplexmodus Daten vom Block 130 im Niederpotentialbereich zum Block 131 im Hochpotentialbereich übermitteln und/oder umgekehrt. Ein Duplexmodus ist bei einem unidirektionalen Betrieb nicht notwendig.

In anderen Worten zeigt Fig. 2 ein Ausführungsbeispiel mit einem Optokoppler, umfassend zwei Transceiver 120, 121 auf einer Leiterplatte 111, wobei die Transceiver tangential zur Leiterplattenoberfläche, beispielsweise entlang der Richtung 140x, kommunizieren.

Hierin beschriebene Optokoppler und/oder Systeme können als integrierte Vorrichtungen und/oder Systeme bereitgestellt werden, was eine einfache Handhabung und gute Herstellbarkeit ermöglichen kann.

Fig. 3 zeigt ein schematisches Blockschaltbild eines Systems 300 gemäß einem Ausführungsbeispiel, das eine oder mehrere der vorteilhaften Ausgestaltungen der Fig. 2 mit implementiert, gegenüber dem System 200 aber eine Modifikation der Haltestruktur 111 bzw. der Leiterplattenstruktur aufweist, dahingehend, dass eine Aussparung entlang einer Strecke zwischen den optischen Vorrichtungen 120 und 121 implementiert ist. Die Strecke zwischen den optischen Vorrichtungen 120 und 121 verläuft beispielsweise entlang der Richtung 140x und die Aussparung 211 umfasst eine Ausdehnung senkrecht hierzu, entlang der Strecke 140y, die zumindest teilweise eine Kriechstromwegverlängerung bereitstellt. Das bedeutet, zwischen den optischen Vorrichtungen 120 und 121 ist ein Weg oder Pfad für Kriechströme basierend auf der Aussparung oder Schlitz 211 verlängert. Eine derartige Aussparung 211 lässt sich mit einfachen Mitteln in die Haltestruktur, beispielsweise eine Leiterplatte, einfügen.

In anderen Worten, um den Einfluss von Kriechströmen an der Leiterplatte und insbesondere im Falle von Feuchtigkeit zu verringern, ist es möglich, im Isolationsbereich 111c eine Aussparung innerhalb des Substrats oder der Leiterplatte vorzusehen. Die Form oder Geometrie einer solchen Unterbrechung kann beliebig sein. In Fig. 3 ist diese beispielhaft als einfacher Schlitz 211 dargestellt, wobei der Schlitz 211 nicht auf der vollen Länge bzw. Breite der Leiterplatte entlang der Richtung 140y ausgeführt sein muss, etwa um an den Seiten noch eine mechanische Stabilität bzw. relative Befestigung zu gewährleisten. Diese kann im Bedarfsfall auch durch zusätzliche mechanische Mittel erhalten werden, um die Aussparung 211 über die gesamte Ausdehnung entlang der Richtung 140y, das heißt, die Breite senkrecht zur Kommunikationsrichtung 140x, durchtrennen zu können.

In anderen Worten zeigt Fig. 3 eine Ausführungsform, bei der die Isolationsspannung dadurch erhöht wird, indem Kriechströme im Bereich der Aussparung vermieden werden. Dies lässt sich im Ausführungsbeispiel der Fig. 3 durch einen einfachen Schlitz in der Leiterplatte ermöglichen.

Eine weitere bevorzugte Ausführungsform ist anhand der Fig. 4 dargestellt. Fig. 4 zeigt ein schematisches Blockschaltbild eines Systems 400 gemäß einem Ausführungsbeispiel, das ebenfalls den Optokoppler 20 umfasst, wobei alternativ oder zusätzlich zu der Aussparung 211 der Fig. 3 ein elektrisch isolierendes Element 212 zur Unterbindung von Kriechströmen entlang der Strecke zwischen den optischen Vorrichtungen 120 und 121 angeordnet ist. Durch diese Barriere kann die Spannungsfestigkeit des Optokopplers 20 und/oder des Systems 400 erhöht werden. Vorteilhafte Materialien dafür sind beispielsweise Quarzmaterialien, Glas, Silicatmaterialien oder Kunststoffe. Das Isolationselement kann eine verglichen mit Luft erhöhte Durchschlagsfestigkeit, von mehr als 100 V, mehr als 1 kV, mehr als 5 kV oder darüber hinaus beispielsweise von 10 kV aufweisen.

In der Ausgestaltung der Fig. 4 ist das Isolationselement 212 im Verlauf des Pfades der optisch-faserlosen Signale 16₁ und 16₂ angeordnet, das bedeutet, die optisch-faserlosen Signale verlaufen durch das Isolationselement 212 hindurch, weswegen es bevorzugt für einen Wellenlängenbereich des optisch-faserlosen Signals 16₁ und/oder 16₂ transparent gebildet ist und in einem Verlauf eines Pfades der optisch-faserlosen Signale 16₁ und 16₂ angeordnet ist. Eine derartige Ausgestaltung bleibt jedoch optional, wenn eine Höhe des Isolationselements 212, etwa entlang der Richtung 140z, so gering ist, dass der Pfad der optisch-faserlosen Signale 16₁ und/oder 16₂ nicht oder nur unwesentlich beeinträchtigt wird. Auch könnte, alternativ oder zusätzlich, eine Aussparung oder ein Loch in dem Isolationselement 212 vorgesehen sein, welches sich beispielsweise nicht auf eine Grundfläche 42 der Haltestruktur 111 erstreckt, weswegen Kriechströme entlang der Richtung 140z verlaufen würden, um zum jeweils anderen optischen Transceiver 120/121 zu gelangen.

Das Isolationselement 211 kann in einem Kontaktbereich, beispielsweise in einem von der Leiterplatte 110 verdeckten Bereich des Isolationselements 211, in die Haltestruktur eingepresst sein und in dem Kontaktbereich Vertiefungen, vereinfacht bezeichnet als Nasen, bezüglich der Haltestruktur aufweisen, die ausgebildet sind, um eine Klemmkraft gegenüber der Haltestruktur bereitzustellen. Anders ausgedrückt kann das Isolationselement 212 beispielsweise in die Aussparung 211 der Fig. 3 eingepresst oder anderweitig befestigt sein. Alternativ könnte das Isolationselement 212 auch an der Oberfläche 42 befestigt oder angeordnet werden, beispielsweise durch einen Fügeprozess.

Es wird darauf hingewiesen, dass das Isolationselement 212 nicht notwendigerweise ein separates Element zur elektrischen Isolation hinsichtlich des Kriechstroms zwischen den optischen Transceivern 120 und 121 ist. In einer vorteilhaften Ausgestaltung, die später noch detailliert beschrieben wird, ist es möglich, dass das Isolationselement 212 die optische Vorrichtung 120 und/oder 121 zumindest teilweise kapselt, was zusätzliche Verbesserung bezüglich der Haltbarkeit und Spannungsfestigkeit ermöglichen kann.

Andere Vorkehrungen zu einer Kriechstromwegverlängerung sind ebenfalls Gegenstand hierin beschriebener Ausführungsbeispiele. Eine derartige Kriechstromwegverlängerung kann in einem Optokoppler gemäß Ausführungsbeispielen ausgebildet sein, um eine Weglänge des Kriechstroms verglichen mit einem direkten Pfad zwischen den optischen Vorrichtungen 120/121 zu verlängern, um die Durchschlagsfestigkeit verglichen mit dem direkten Pfad zu erhöhen.

In anderen Worten lässt sich die Isolationsspannung verglichen mit der Fig. 3 noch weiter erhöhen, indem in den Schlitz 212 ein Material mit höherer Spannungsfestigkeit eingefügt wird. Dies ist in Fig. 4 durch den Block 212 dargestellt. Bei dem eingefügten Isolator kann es sich beispielsweise um einen kostengünstigen Kunststoff handeln, der bereits eine deutlich höhere Spannungsfestigkeit als Luft aufweisen kann. Der Isolator kann beispielsweise an einem unteren Ende mit kleinen Nasen, Erhebungen oder Vertiefungen ausgeführt sein, so dass er für die Montage einfach in den Schlitz eingepresst und dann festklemmt werden kann.

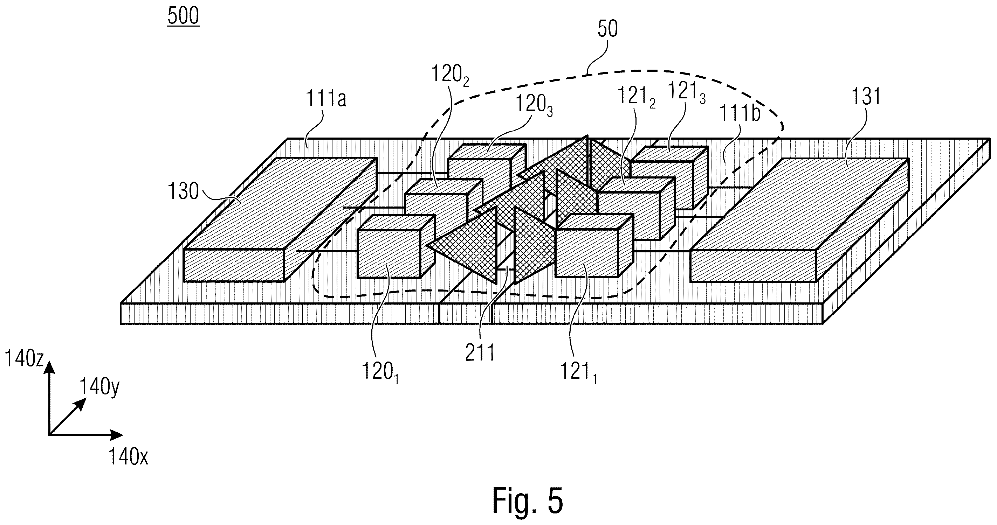

Fig. 5 zeigt ein schematisches Blockschaltbild eines Systems 500 gemäß einem Ausführungsbeispiel, bei dem ein Optokoppler 50 mehrere Übertragerpaare für optisch-faserlose Signale umfasst. So bilden beispielsweise jeweilige erste optische Vorrichtungen 120₁, 120₂ und 120₃ mit einer jeweilig zweiten optischen Vorrichtung 121₁, 121₂ und 121₃ ein Übertragerpaar, das heißt, die Kombination der optischen Vorrichtungen 120₁, 121₁; 120₂, 121₂; und 120₃, 121₃ bildet eines von insgesamt drei dargestellten Übertragerpaaren, wobei die Anzahl von 3 Übertragerpaaren beispielhaft ist und einen beliebigen Wert von zumindest 2, zumindest 3, zumindest 4 oder mehr, etwa zumindest 5, zumindest 7 oder zumindest 10 umfassen kann. Auch wenn das System 500 im jeweiligen Übertragerpaar für eine bidirektionale Kommunikation ausgebildet ist, können andere Ausführungsbeispiele mit einer unidirektionalen Kommunikation zumindest bei einem der Übertragerpaare implementiert werden.

Die Übertragerpaare können einen zeitlich und/oder räumlich parallelen Betrieb übermittelter optisch-faserloser Signale ermöglichen, etwa indem diese nebeneinander an der Haltestruktur angeordnet sind und/oder unterschiedliche Wellenlängen für die optisch-faserlosen Signale implementieren. Unterschiedliche Übertragerpaare können für unterschiedliche optisch-faserlose Kanäle und/oder für unterschiedliche Zwecke und/oder unterschiedliche Übertragungsrichtungen eingesetzt werden. So können basierend auf voneinander verschiedenen Sensorelementen, die beispielsweise mit dem Block 130 und/oder 131 verbunden sind, für verschiedene Sensorelemente Sensordaten für voneinander verschiedene Sensorkanäle mit voneinander verschiedenen Übertragerpaaren gesendet werden. Alternativ oder zusätzlich können die verschiedenen Datenkanäle auch genutzt werden, um anderen Signale, wie bspw. Steuersignale zu übertragen und/oder um in zumindest einem Kanal ein Steuersignal und in zumindest einem anderen Kanal ein Sensorsignal zu übertragen.

In anderen Worten zeigt Fig. 5 eine Ausführungsform, bei der die Bandbreite des Optokopplers vergrößert ist, indem mehrere Transceiver nebeneinander platziert werden. In Fig. 5 ist dies durch die Transceiver 120₁, 120₂, 120₃ bzw. 121₁, 121₂, 121₃ angedeutet. Ein Kanalübersprechen kann vermieden werden bzw. hinreichend minimiert werden, indem die Transceiver sehr gerichtet senden bzw. empfangen, was durch eine jeweilige Kanaloptik implementiert werden kann. Alternativ oder zusätzlich kann der Abstand zwischen den Vorrichtungen unterschiedlicher Übertragerpaare, beispielsweise entlang der Richtung 140y, hinreichend groß gewählt werden, was eine zusätzliche Diversität im Wellenlängenbereich nicht ausschließt, wonach zumindest benachbarte Übertragerpaare unterschiedliche und bevorzugt disjunkte Wellenlängenbereiche nutzen, zumindest hinsichtlich der Empfangsoptik.

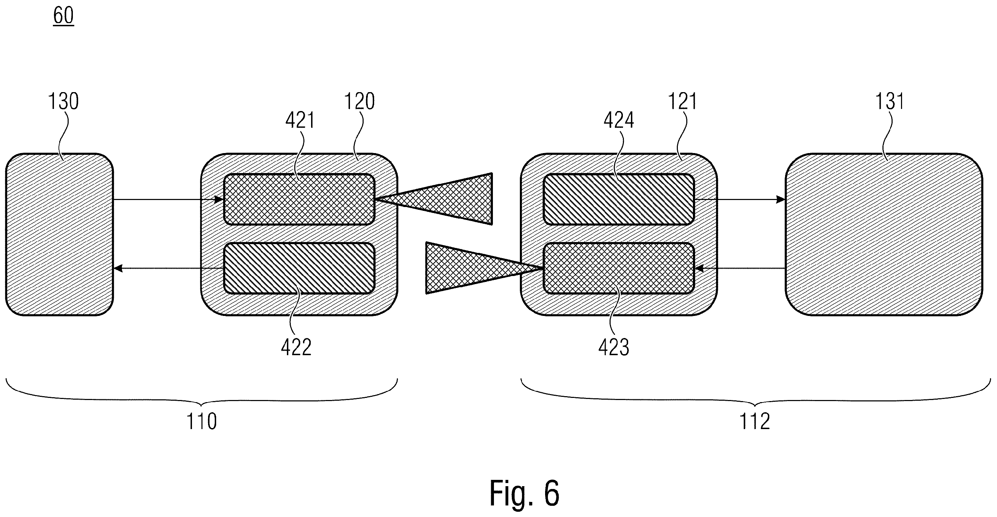

Fig. 6 zeigt ein schematisches Blockschaltbild eines Optokopplers 60 gemäß einem Ausführungsbeispiel, bei dem die Haltestruktur nicht dargestellt ist, die Datenquelle 130 sowie der Datenempfänger 131 dafür Teil des Optokopplers 60 sind. In der Ausführungsform der Fig. 6 können Daten vom Block 130 an den Transceiver 120 gesendet werden. Ein Transmitter 421 des Transceivers 120 kann ausgebildet sein, um die Daten zu einem optischen Empfänger 424 des Transceivers 121 zu senden, welcher beispielsweise in einer Domäne mit hohem elektrischen Potential angeordnet ist.

Die Daten werden dann zum Block 131 weitergeleitet. Die Daten können auch vom Block 131 über den Sender 423 des Transceivers 121 an den Empfänger 422 des Transceivers 120 übermittelt werden. Von da aus können sie an den Block 130 weitergeleitet werden.

Der Transmitter 421 des Transceivers 120kann räumlich beliebig zum Receiver 424 des Transceivers 121 angeordnet sein. Gleichfalls kann der Transmitter 423 des Transceivers 121 räumlich beliebig zum Receiver 422 des Transceivers 120 angeordnet sein. Das heißt, es ist denkbar, dass Transmitter und Receiver nebeneinander, beispielsweise entlang der Richtung 140y, siehe beispielsweise Fig. 4, angeordnet sind. Es ist aber auch denkbar, dass Transmitter und Receiver übereinander angeordnet sind, das heißt, entlang der Achse 140z. Eine radiale Anordnung ist aber auch denkbar, beispielsweise dahingehend, dass der Transmitter innerhalb einer kreisförmigen Receiver-Apertur angeordnet ist oder andersherum, also der optische Transmitter den optischen Receiver an der Ausgangsapertur umschließt; oder der optische Empfänger den optischen Transmitter an der Ausgangsapertur umschließt, etwa als ununterbrochene oder unterbrochene Ringe, Ellipsen oder Polygone.

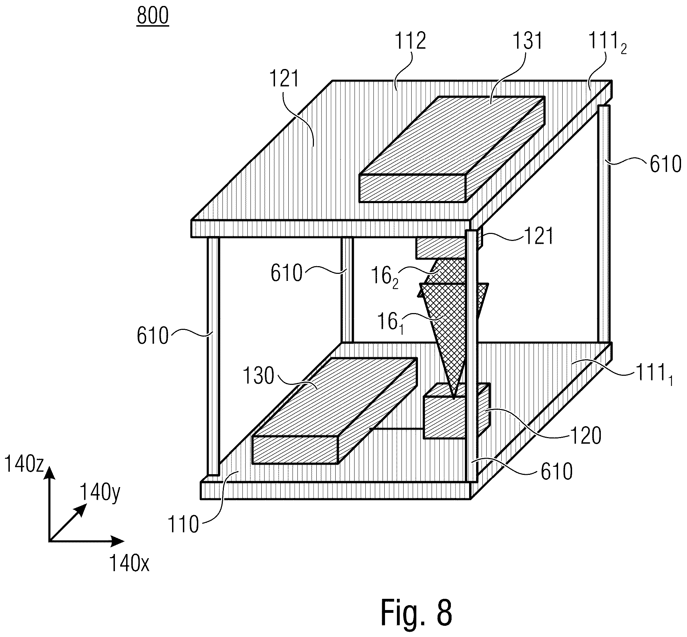

Eine Anordnung übereinander, etwa dahingehend, dass der Optokoppler für einen Betrieb in einer Optikanordnung eingerichtet ist, wobei sich die Optikanordnung parallel zu einer Optikebene erstreckt, beispielsweise parallel zu einer 140x/140y-Ebene, kann auch beispielsweise unter Verweis auf die Fig. 8 so erfolgen, dass die erste optische Vorrichtung und die zweite optische Vorrichtung in unterschiedlichen Ebenen gegenüberliegend und/oder gestapelt angeordnet sind. Abweichend hiervon ist beispielsweise anhand den Fig. 2, 3 und 4 eine Anordnung dargestellt, bei der die Optikanordnung beispielsweise auf der Leiterplatte 111 angeordnet ist und eine Optikebene beispielsweise an, auf oder in der Oberfläche 42 angeordnet ist und die optischen Vorrichtungen zumindest im Wesentlichen in einer übereinstimmenden Ebene parallel zu der Optikebene angeordnet sind. Dadurch erfolgt ein Versatz zwischen den beiden Transmittern entlang lediglich einer Richtung, bevorzugt der Ausbreitungsrichtung des optisch-faserlosen Signals.

Eine weitere Ausgestaltung der radialen Anordnung kann so implementiert sein, dass ein optischer Transmitter eines Transceivers und ein optischer Empfänger der anderen optischen Vorrichtung in einer radialen Anordnung positioniert sind, so dass das optisch-faserlose Signal radial nach außen oder radial nach innen gesendet wird.

Unter erneuter Bezugnahme auf die Fig. 6 kann der Block 131 und/oder der Block 130 als Datenquelle ausgeführt sein. Beispielsweise kann dieser Block einen oder mehrere Sensoren aufweisen, die beispielsweise mit einem oder mehreren Analog-zu-Digital-Wandlern (ADCs) große Datenmengen generieren können. Im Falle eines ADCs können diese Daten seriell über den Optokoppler übertragen werden. Falls notwendig, können sie hierfür mit einem Multiplexer zuvor in einen seriellen Bitstrom mit hoher Datenrate gewandelt werden. Es ist auch denkbar, ADC-Daten oder Datenströme von einzelnen oder verschiedenen Sensoren parallel zu übertragen, indem mehrere Transceiver nebeneinander platziert werden, siehe Fig. 5. So können auch Abtastraten (Sample-Raten) mit GS/s hoher Auflösung übermittelt werden.

Bei dem Block 131 kann es sich um einen oder mehrere Chips und/oder Sensoren handeln. Es ist möglich, dass ein FPGA/ASIC eingesetzt wird, der beispielsweise einen integrierten ADC aufweist, welcher die Daten generieren kann. Es ist auch möglich, dass der FPGA/ASIC die Daten von einem Sensor über eine Datenschnittstelle erhält oder empfängt.

Der Block 130 kann beispielsweise Sensordaten über den Optokoppler aus der Hochpotentialdomäne 112 empfangen. Der Block 130 kann diese Daten weiterverarbeiten. Es ist auch denkbar, eine Datenverarbeitung im Block 131 durchzuführen, allerdings ist die verfügbare Leistung in der Hochvoltdomäne oder Hochpotentialdomäne 112 in der Regel begrenzt, so dass es vorteilhaft sein kann, leistungsintensive Berechnungen in der Niederpotentialdomäne 110 auszuführen. Der Block 130 kann außerdem eine Peripherie bereitstellen, die ein oder mehrere Interfaces oder Schnittstellen bereitstellen kann, mit welchen die Daten in ein Netzwerk eingegeben oder an andere Endgeräte verteilt werden können. Es wird erneut darauf hingewiesen, dass eine Richtung, in der Daten übertragen werden, lediglich beispielhaft und insbesondere vor dem Lichte der Niederpotentialseite und Hochpotentialseite exemplarisch gewählt sind und problemlos die Richtung invertiert werden kann bzw. in eine bidirektionale Kommunikation erweitert werden kann. In manchen Ausführungsformen ist vorgesehen, dass In der Hochpotentialdomäne mittels Sensoren Daten generiert werden und eine Datenquelle implementiert ist, wobei die Daten über den Optokoppler gesendet werden. Darüber hinaus können Einstellungen oder Konfigurationen an den Schaltkreisen und/oder Sensoren in der Hochpotentialdomäne über Steuersignale vorgenommen werden, welche in Richtung der Sensoren übermittelt werden, womit in der Hochpotentialdomäne auch eine Datensenke implementiert ist.

In anderen Worten zeigt Fig. 6 ein elektronisches Blockdiagramm eines erfindungsgemäßen Optokopplers.

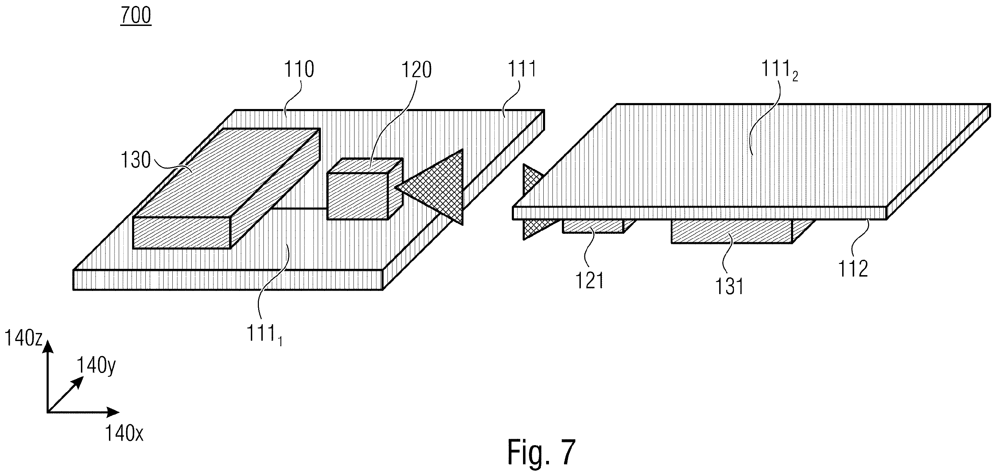

Fig. 7 zeigt eine schematische perspektivische Ansicht eines Systems 700, bei dem die Leiterplattenstruktur 111 des Systems 200 so modifiziert ist, dass zumindest hinsichtlich des Optokopplers die erste optische Vorrichtung 120 an einem ersten Leiterplattenelement 111₁ und die zweite optische Vorrichtung 121 an einem hiervon verschiedenen zweiten Leiterplattenelement 111₂ angeordnet ist, wobei die Leiterplattenelemente 111₁ und 111₂ räumlich beabstandet voneinander sind. Eine relative Ausrichtung zueinander kann eine nicht dargestellte Erweiterung der Haltestruktur gewährleisten. In einer hiervon unabhängigen Ausgestaltung sind Optikmontageseiten, also Seiten der Leiterplattenelemente 111₁ und 111₂, an welchen die optischen Vorrichtungen angeordnet sind, einander zugewandt, wie es in der Fig. 7 dargestellt ist, oder einander abgewandt. Auch ist es nicht erforderlich, dass die Optikmontageseiten, wie dargestellt, parallel zueinander verlaufen.

In anderen Worten zeigt Fig. 7 ein weiteres Ausführungsbeispiel, bei dem die beiden Transceiver auf unterschiedlichen Leiterplatten 111₁ und 111₂ platziert werden. Die Leiterplatten sind in diesem Ausführungsbeispiel zueinander verdreht, wobei dies optional ist.

Werden zwei separate Leiterplattenelemente verwendet, kann der Felddurchbruch an den Leiterplattenoberflächen verglichen mit einer einstückigen Ausgestaltung unwahrscheinlicher werden, auch wenn dies die Platzierung von Komponenten über zwei Leiterpleiten hinweg erfordert. So kann das Problem auf einen Felddurchbruch an der Gehäuseoberfläche einer Vorrichtung begrenzt werden, was ebenfalls einfach überwunden werden kann.

Fig. 8 zeigt ein schematisches Blockschaltbild eines Systems 800 gemäß einem Ausführungsbeispiel, bei dem die Transceiver 120 und 121 des Optokopplers an zwei verschiedenen Leiterplattenelementen 111₁ bzw. 111₂ angeordnet sind, deren Optikmontageseiten einander zugewandt angeordnet sind, wie es im Zusammenhang mit der Fig. 7 beschrieben ist. Die Leiterplattenelemente 111₁ und 111₂ können gegenüberliegend zueinander angeordnet sein, so dass die Aussendung optisch-faserloser Signale im Wesentlichen senkrecht zu einer Substratoberfläche erfolgen kann.

Wie es anhand des Blocks 131 dargestellt ist, kann eine Datenquelle und/oder ein Datenempfänger auf der gleichen Seite, der Optikmontageseite angeordnet sein oder einer gegenüberliegenden Seite. Es wird deutlich, dass ein Oberflächenbedarf, etwa hinsichtlich Chipfläche oder auf der Leiterplatte, mit einer Anordnung gemäß Fig. 8 reduziert werden kann. Eine Beibehaltung der relativen Positionierung kann dennoch sichergestellt sein, indem die Haltestruktur Abstandshalter 610 aufweist, die an zumindest einer Stelle die Leiterplattenelemente 111₁ und 111₂ relativ zueinander positioniert, bevorzugt an oder in Bereichen, wo die optische Kommunikation höchstens geringfügig beeinflusst ist oder unbeeinflusst ist.

In anderen Worten zeigt Fig. 8 ein weiteres Ausführungsbeispiel, bei dem nicht tangential zur Leiterplattenoberfläche, sondern senkrecht zur Leiterplattenoberfläche, beispielsweise entlang der Richtung 140z, innerhalb des Optokopplers kommuniziert wird. Die beiden Transceiver 120, 121 sitzen auf unterschiedlichen Leiterplatten. Beide Leiterplatten können, müssen aber nicht miteinander befestigt sein. Es ist beispielsweise denkbar, die Leiterplatten mit den Abstandshaltern 610 zu fixieren. Diese Abstandshalter können aus einem Isolator, beispielsweise Keramik oder Kunststoff, gefertigt sein oder diesen umfassen, um eine hohe Isolationsspannung zu erreichen.

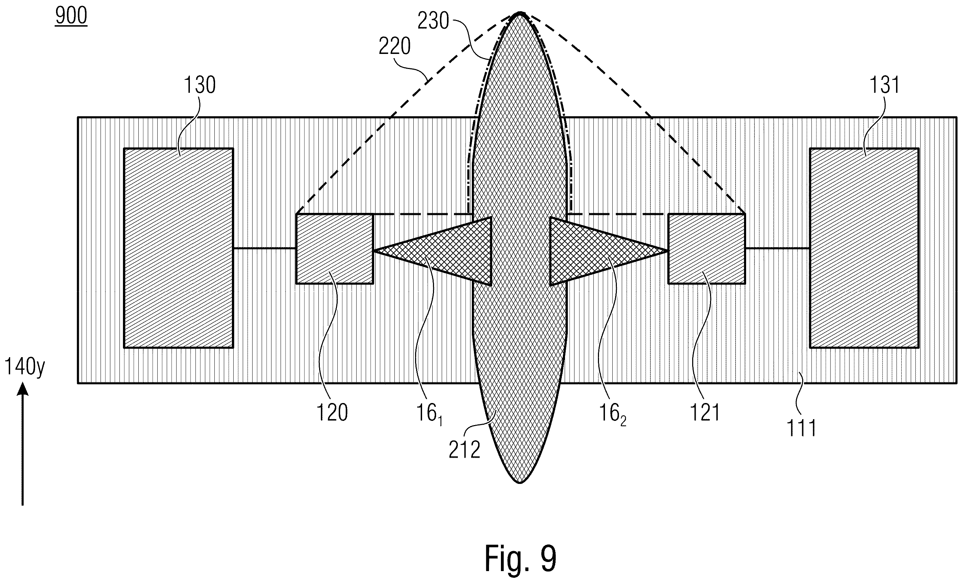

Fig. 9 zeigt eine schematische Draufsicht auf ein System 900 gemäß einem Ausführungsbeispiel, welches eine Abwandlung des Systems 400 darstellen kann. Darin ist das Isolationselement 212 so ausgestaltet, dass es über die Leiterplatte 111 entlang positiver und negativer Richtung 140y hinausragt, was die Isolationseigenschaften des Isolationselements 212 weiter verbessert.

In anderen Worten zeigt Fig. 9 eine Draufsicht auf den mit einem Isolator versehenen Optokoppler, welcher eine Kriechstrecke 230 und eine Luftstrecke 220 zwischen elektrischen Kontakten der Transceiver 120, 121 erhöht und somit die Durchschlagsfestigkeit erhöht. Dabei sind beide Transceiver auf einer Leiterplatte 111 angeordnet, so dass sie eine komplette Optokoppler-Einheit bilden können. Auf diese Weise kann ein besonders kompakter Optokoppler erreicht werden. Der Isolator 212 kann beispielsweise aus einem optisch transparenten Kunststoff gefertigt sein, zumindest hinsichtlich der optisch-faserlosen Signale 16₁ und 16₂. In weiter anderen Worten zeigt Fig. 9 ein Ausführungsbeispiel des Optokopplers mit einem speziell für die Erhöhung der Isolation ausgeformten optisch transparenten Isolator.

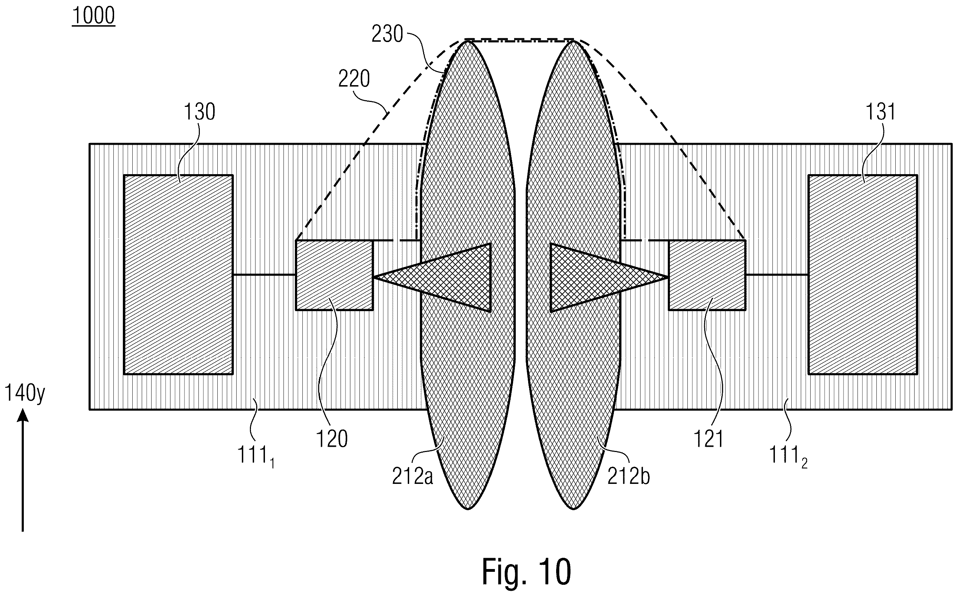

Ausgehend von Fig. 9 zeigt Fig. 10 eine schematische Draufsicht auf ein System 1000, bei der die Leiterplattenstruktur 111 in zwei Leiterplattenelemente 111₁ und 111₂ unterteilt ist, wie es im Zusammenhang mit der Fig. 7 beschrieben ist. Ferner ist ein elektrisches Isolationselement 212a an dem ersten Leiterplattenelement 111₁ angeordnet und dem zweiten Leiterplattenelement 111₂ zugewandt angeordnet. Ein weiteres elektrisches Isolationselement 212b ist an dem zweiten Leiterplattenelement 111₂ angeordnet und dem ersten Leiterplattenelement 111₁ zugewandt angeordnet. Anders ausgedrückt kann das Isolationselement 212 des Systems 900 ähnlich unterteilt sein wie die Leiterplattenstruktur 111, wobei die Elemente auch ohne Isolationselement ausgebildet sein können, wie es in Fig. 7 dargestellt ist oder lediglich an einem der beiden Leiterplattenelemente 111₁ oder 111₂ ein Isolationselement angeordnet sein kann. Eine Ausgestaltung gemäß der Fig. 10 ermöglicht es jedoch, gleiche oder gar identische Einzelkomponenten des Gesamtsystems 1000 herzustellen und bezüglich einander anzuordnen und mit einer Haltestruktur gegeneinander zu befestigen.

In anderen Worten zeigt Fig. 10 eine ähnliche Ausformung wie Fig. 9. Gezeigt ist eine Ausführung mit zwei getrennten Leiterplatten 111₁ und 111₂, wobei auch der Isolator 212a und 212b auf jeder Seite des Optokopplers enthalten ist, was eine modulare Bauweise ermöglicht. Auf diese Weise kann der Optokoppler mit unterschiedlichen Abständen zwischen den optischen Vorrichtungen realisiert werden und so unterschiedliche Spannungsfestigkeiten erhalten werden. Es wäre denkbar, dass durch die erhöhte Spannungsfestigkeit aufgrund des Isolators 212a und 212b die beiden Seiten des sich dann bildenden Optokopplers mit einem geringeren Abstand angeordnet werden können als die typischerweise auf Leiterplatten eingehaltenen Abstände zwischen Hochspannungsbereich und Niederspannungsbereich, der nach VDE 110 typischerweise 0,005 mm/V beträgt. In weiter anderen Worten zeigt Fig. 10 ein Ausführungsbeispiel eines modularen Optokopplers mit jeweils einem speziell zur Erhöhung der Isolation ausgeformten optisch transparenten Isolator je Modul.

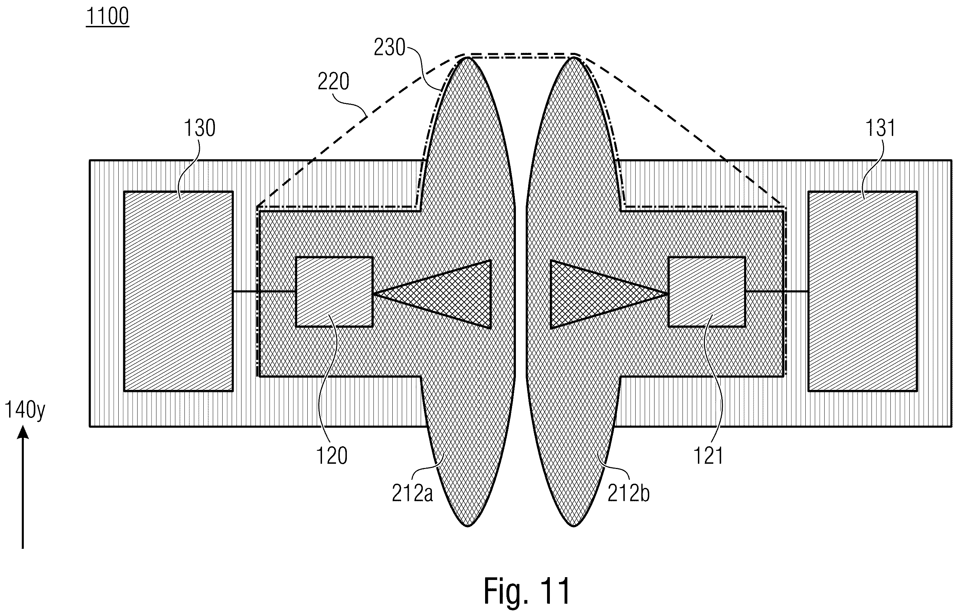

Fig. 11 zeigt eine schematische Draufsicht auf ein System 1100 gemäß einem Ausführungsbeispiel, das das Ausführungsbeispiel der Fig. 10 weiter ausgestaltet, indem das elektrische Isolationselement 212a die erste optische Vorrichtung 120 ganz oder teilweise kapselt und/oder das elektrische Isolationselement 212b die zweite optische Vorrichtung 121 ganz oder teilweise kapselt. Eine Kapselung kann sich dabei insbesondere auf die elektrischen Kontakte beziehen, ist aber nicht hierauf beschränkt. Vermittels der Kapselung kann die elektrische Isolationsfähigkeit weiter verbessert werden, es kann aber auch alternativ oder zusätzlich ein Schutz vor Umwelteinflüssen erhalten werden, etwa hinsichtlich Schmutzpartikeln und/oder Feuchtigkeit. Hierzu kann das Isolationselement 212a, 212b als eine Art Deckel auf die optische Vorrichtung 120, 121 aufgebracht werden, etwa durch Stecken oder Kleben, die optische Vorrichtung 120 oder 121 kann aber auch in den Isolator eingegossen werden, was die Dichtigkeit erhöhen kann aber womöglich eine Austauschbarkeit des Isolators verhindern kann.

In anderen Worten zeigt Fig. 11 ein Ausführungsbeispiel eines modularen Optokopplers mit jeweils einem speziell zur Erhöhung der Isolation ausgeformten optisch transparenten Isolator je Modul, wobei der Isolator die Transceiver-Module einbezieht, um die Isolation weiter zu erhöhen.

Ausführungsformen der vorliegenden Erfindung beziehen sich im Weiteren auf die Strahlformung der hierin beschriebenen optischen Vorrichtungen bzw. Transceiver. So kann im Rahmen hierin beschriebener Ausführungsbeispiele jeder der Transceiver beispielsweise in Übereinstimmung mit DE 10 2023 204 393 A1 gebildet sein. Ein derartiger Transceiver kann als Komponente auf eine Leiterplatte in hierin beschriebenen Ausführungsbeispielen gesetzt werden und kann Daten tangential zur Leiterplattenoberfläche übermitteln. Die Linse des Transceivers kann dabei so ausgeführt sein, dass die Kommunikation bidirektional, das heißt, in beide Richtungen möglich ist. Sendekanal und Empfangskanal liegen räumlich übereinander, so dass zwei gegenüberliegende Transceiver auch miteinander kommunizieren können, wenn sie in Bezug auf die optische Achse verdreht sind. Im Rahmen hierin beschriebener Ausführungsbeispiele ist es insofern möglich, die beiden Transceiver auf zwei getrennte Leiterplatten zu platzieren und die beiden Leiterplatten um die optische Achse der Transceiver zu rotieren und die Kommunikation funktioniert dennoch, siehe hierzu beispielsweise die Fig. 7. Alternativ oder zusätzlich kann eine Form oder Ausgestaltung zumindest einer der hierin beschriebenen optischen Vorrichtungen in Übereinstimmung mit der US 2021/143912 A1 sein, etwa um eine Abstrahlung orthogonal zur Leiterplattenoberfläche umzusetzen, wie sie beispielsweise im System 800 genutzt wird.

Ausgehend von diesen Referenzen kann die erste optische Vorrichtung ausgebildet sein, um das optisch-faserlose Signal im Wesentlichen parallel zu einer Montageoberfläche auszusenden, an welcher die erste optische Vorrichtung angeordnet ist, beispielsweise die Optikebene, oder bei dem die erste optische Vorrichtung ausgebildet ist, um das optisch-faserlose Signal im Wesentlichen senkrecht zu der Montageoberfläche auszusenden, wobei die Umlenkung einer Strahlrichtung, etwa unter Verwendung von Spiegeln oder dergleichen, ohne weiteres möglich ist.

Im Folgenden werden zusätzliche Ausführungsbeispiele und Aspekte der Erfindung beschrieben, die einzeln oder in Kombination mit beliebigen der hierin beschriebenen Merkmale, Funktionalitäten und Einzelheiten verwendet werden können.

Gemäß einem ersten Aspekt kann ein Optokoppler folgende Merkmale aufweisen: eine erste optische Vorrichtung 12; 120 mit einer strahlformendend Optik 14, die ausgebildet ist, um ein optisch-faserloses Signal 16 mit der strahlformenden Optik 14 auszusenden; eine galvanisch von der ersten optischen Vorrichtung 12; 120 getrennte zweite optische Vorrichtung 18; 121, die ausgebildet ist, das optisch-faserlose Signal 16 zu empfangen und in ein elektrisches Signal 24 zu überführen; und eine Haltestruktur 28; 111; 610, die ausgebildet ist, um die erste optische Vorrichtung 12; 120 und die zweite optische Vorrichtung 18; 121 für das Senden und Empfangen des optisch-faserlosen Signals 16 in einer festen Relativposition zueinander zu positionieren.

Gemäß einem zweiten Aspekt unter Bezugnahme auf den ersten Aspekt kann eine optische Übertragungsstrecke 26 zwischen der ersten optischen Vorrichtung 12; 120 und der zweiten optischen Vorrichtung 18; 121 eine Länge von zumindest 5 mm aufweisen.

Gemäß einem dritten Aspekt unter Bezugnahme auf den ersten oder zweiten Aspekt kann das optisch-faserlose Signal 16 ein erstes optisch-faserloses Signal 16₁ sein; wobei die zweite optische Vorrichtung 18; 121 ausgebildet sein kann, um ein zweites optisch-faserloses Signal 16₂ an die erste optische Vorrichtung 12; 120 zu senden.

Gemäß einem vierten Aspekt unter Bezugnahme auf zumindest einen des ersten bis dritten Aspekts kann der Optokoppler einen elektrischen Isolationsbereich 111c zwischen der ersten optischen Vorrichtung 12; 120 und der zweiten optischen Vorrichtung 18; 121 aufweisen.

Gemäß einem fünften Aspekt unter Bezugnahme auf zumindest einen des ersten bis vierten Aspekts kann die Haltestruktur eine Leiterplattenstruktur 111 umfassen und die erste optische Vorrichtung 12; 120 und die zweite optische Vorrichtung 18; 121 an der Leiterplattenstruktur 111 angeordnet sein.

Gemäß einem sechsten Aspekt unter Bezugnahme auf den fünften Aspekt kann die erste optische Vorrichtung 12; 120 an einer Optikmontageseite eines ersten Leiterplattenelements 111₁ der Leiterplattenstruktur angeordnet ist, und die zweite optische Vorrichtung 18; 121 an einer Optikmontageseite eines räumlich beabstandeten zweiten Leiterplattenelements 111₂ angeordnet ist, wobei die Optikmontageseite einander zugewandt oder einander abgewandt sind.

Gemäß einem siebten Aspekt unter Bezugnahme auf den fünften oder sechsten Aspekt kann der Optokoppler ein erstes elektrisches Isolationselement 212a, das an dem ersten Leiterplattenelement 111₁ und dem zweiten Leiterplattenelement 111₂ zugewandt angeordnet ist; und ein zweites elektrisches Isolationselement 212b aufweisen, das an dem zweiten Leiterplattenelement 111₂ und dem ersten Leiterplattenelement 111₁ zugewandt angeordnet ist.

Gemäß einem achten Aspekt unter Bezugnahme auf den siebten Aspekt kann das erste elektrische Isolationselement 212a die erste optische Vorrichtung 12; 120 zumindest teilweise kapseln; und/oder bei dem das zweite elektrische Isolationselement 212b die zweite optische Vorrichtung 18; 121 zumindest teilweise kapseln.

Gemäß einem neunten Aspekt unter Bezugnahme auf zumindest einen des fünften bis achten Aspekts kann die Leiterplattenstruktur eine Aussparung 211 entlang einer Strecke zwischen der ersten optischen Vorrichtung 12; 120 und der zweiten optischen Vorrichtung 18; 121 umfassen, die eine Ausdehnung senkrecht zu der Strecke aufweist, um eine Kriechstromwegverlängerung bereitzustellen.

Gemäß einem zehnten Aspekt unter Bezugnahme auf zumindest einen des fünften bis neunten Aspekts kann die Haltestruktur 28; 111; 610 ein elektrisch isolierendes Isolationselement 212 umfassen, das entlang einer Stecke zwischen der ersten optischen Vorrichtung 12; 120 und der zweiten optischen Vorrichtung 18; 121 zumindest teilwiese angeordnet ist.

Gemäß einem elften Aspekt unter Bezugnahme auf den zehnten Aspekt kann das Isolationselement 212 für einen Wellenlängenbereich des optisch-faserlosen Signals 16 transparent gebildet sein und in einem Verlauf eines Pfades des optisch-faserlosen Signals 16 angeordnet sein.

Gemäß einem zwölften Aspekt unter Bezugnahme auf den zehnten oder elften Aspekt kann das Isolationselement 212 in einem Kontaktbereich in eine Aussparung der Haltestruktur 111 eingepresst sein und in dem Kontaktbereich Erhebungen oder Vertiefungen bezüglich der Haltestruktur 111 aufweisen, die ausgebildet sind, um eine Klemmkraft gegenüber der Haltestruktur bereitzustellen.

Gemäß einem dreizehnten Aspekt unter Bezugnahme auf zumindest einen des zehnten bis zwölften Aspekts kann das Isolationselement 212 die erste optische Vorrichtung 12; 120 und/oder die zweite optische Vorrichtung 18; 121 zumindest teilweise kapseln.

Gemäß einem vierzehnten Aspekt unter Bezugnahme auf zumindest einen des ersten bis dreizehnten Aspekts kann der Optokoppler eine Kriechstromwegverlängerung umfassen, die ausgebildet ist, um eine Weglänge eines Kriechstroms 230 verglichen mit einem direkten Pfad und zwischen der ersten optischen Vorrichtung 12; 120 und der zweiten optischen Vorrichtung 18; 121 zu verlängern.

Gemäß einem fünfzehnten Aspekt unter Bezugnahme auf zumindest einen des ersten bis vierzehnten Aspekts können die erste optische Vorrichtung 12; 120 und die zweite optische Vorrichtung 18; 121 ein erstes Übertragerpaar bilden und kann eine Mehrzahl von für einen zeitlich und/oder räumlich parallelen Betrieb eingerichtete Übertragerpaaren an der Haltestruktur 28; 111; 610 angeordnet sein.

Gemäß einem sechzehnten Aspekt unter Bezugnahme auf den fünfzehnten Aspekt kann der Optokoppler ausgebildet sein, um basierend auf voneinander verschiedenen Sensorelementen Sensordaten für voneinander verschiedene Sensorkanäle mit voneinander verschiedenen Übertragerpaaren zu übertragen.

Gemäß einem siebzehnten Aspekt unter Bezugnahme auf zumindest einen des ersten bis sechzehnten Aspekts kann der Optokoppler für einen Betrieb in einer Optikanordnung eingerichtet sein, wobei sich die Optikanordnung parallel zu einer Optikebene erstreckt, wobei die erste optische Vorrichtung 12; 120 und die zweite optische Vorrichtung 18; 121 in einer übereinstimmenden Ebene parallel zu der Optikebene angeordnet sind.

Gemäß einem achtzehnten Aspekt unter Bezugnahme auf zumindest einen des ersten bis sechzehnten Aspekts kann der Optokoppler für einen Betrieb in einer Optikanordnung eingerichtet sein, wobei sich die Optikanordnung parallel zu einer Optikebene erstreckt, wobei die erste optische Vorrichtung 12; 120 und die zweite optische Vorrichtung 18; 121 in unterschiedlichen Ebenen gegenüberliegend angeordnet sind.

Gemäß einem neunzehnten Aspekt unter Bezugnahme auf zumindest einen des ersten bis sechzehnten Aspekts kann ein optischer Transmitter der ersten optischen Vorrichtung 12; 120 und ein optischer Empfänger der zweiten optischen Vorrichtung 18; 121 in einer radialen Anordnung positioniert sein und der optische Transmitter den optischen Empfänger an der Ausgangsapertur umschließen; oder der optische Empfänger den optischen Transmitter an der Ausgangsapertur umschließen.

Gemäß einem zwanzigsten Aspekt unter Bezugnahme auf zumindest einen des ersten bis neunzehnten Aspekts kann der Optokoppler als integrierte Vorrichtung gebildet oder Teil eines integrierten Systems sein.

Gemäß einem einundzwanzigsten Aspekt unter Bezugnahme auf zumindest einen des ersten bis zwanzigsten Aspekts kann die erste optische Vorrichtung 12; 120 ausgebildet sein, um das optisch-faserlose Signal 16 im Wesentlichen parallel zu einer Montageoberfläche auszusenden, an welcher die erste optische Vorrichtung 12; 120 angeordnet ist; oder bei dem die erste optische Vorrichtung 12; 120 ausgebildet ist, um das optisch-faserlose Signal 16 im Wesentlichen senkrecht zu der Montageoberfläche auszusenden.

Gemäß einem zweiundzwanzigsten Aspekt kann ein System folgende Merkmale aufweisen: einen Optokoppler gemäß zumindest einem der vorangehenden Aspekte; und eine Datenquelle 130, die mit der ersten optischen Vorrichtung 12; 120 gekoppelt ist, um vermittels des optisch-faserlosen Signals 16 Daten an die zweite optische Vorrichtung 18; 121 zu senden; und einen Datenempfänger 131, der ausgebildet ist, um die Daten von der zweiten optischen Vorrichtung 18; 121 zu empfangen.

Gemäß einem dreiundzwanzigsten Aspekt unter Bezugnahme auf den zweiundzwanzigsten Aspekt kann die Datenquelle einen oder mehrere Sensoren, ein feldprogrammierbares Gatterarray, FPGA, und/oder einen funktionsspezifischen integrierten Schaltkreis, ASIC, umfassen.

Gemäß einem vierundzwanzigsten Aspekt unter Bezugnahme auf den zweiundzwanzigsten oder dreiundzwanzigsten Aspekt kann die Datenquelle 130 mit einer Hochpotentialseite des Systems und der Datenempfänger 131 mit einer Niederpotentialseite des Systems elektrisch gekoppelt sein.

Gemäß einem fünfundzwanzigsten Aspekt unter Bezugnahme auf zumindest einen des zweiundzwanzigsten bis vierundzwanzigsten Aspekts kann das System als integriertes System gebildet sein.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Optokoppler mit:
einer ersten optischen Vorrichtung (12; 120) mit einer strahlformendend Optik (14), die ausgebildet ist, um ein optisch-faserloses Signal (16) mit der strahlformenden Optik (14) auszusenden;
einer galvanisch von der ersten optischen Vorrichtung (12; 120) getrennten zweiten optischen Vorrichtung (18; 121), die ausgebildet ist, das optisch-faserlose Signal (16) zu empfangen und in ein elektrisches Signal (24) zu überführen;
einer Haltestruktur (28; 111; 610), die ausgebildet ist, um die erste optische Vorrichtung (12; 120) und die zweite optische Vorrichtung (18; 121) für das Senden und Empfangen des optisch-faserlosen Signals (16) in einer festen Relativposition zueinander zu positionieren.

2. Optokoppler gemäß Anspruch 1, bei dem eine optische Übertragungsstrecke (26) zwischen der ersten optischen Vorrichtung (12; 120) und der zweiten optischen Vorrichtung (18; 121) eine Länge von zumindest 5 mm aufweist.

3. Optokoppler gemäß Anspruch 1 oder 2, bei der das optisch-faserlose Signal (16) ein erstes optisch-faserloses Signal (16₁) ist; wobei die zweite optische Vorrichtung (18; 121) ausgebildet ist, um ein zweites optisch-faserloses Signal (16₂) an die erste optische Vorrichtung (12; 120) zu senden.

4. Optokoppler gemäß einem der vorangehenden Ansprüche, bei dem die Haltestruktur eine Leiterplattenstruktur (111) umfasst und die erste optische Vorrichtung (12; 120) und die zweite optische Vorrichtung (18; 121) an der Leiterplattenstruktur (111) angeordnet sind.

5. Optokoppler gemäß Anspruch 4, bei der die erste optische Vorrichtung (12; 120) an einer Optikmontageseite eines ersten Leiterplattenelements (111₁) der Leiterplattenstruktur angeordnet ist, und die zweite optische Vorrichtung (18; 121) an einer Optikmontageseite eines räumlich beabstandeten zweiten Leiterplattenelements (111₂) angeordnet ist, wobei die Optikmontageseite einander zugewandt oder einander abgewandt sind.

6. Optokoppler gemäß Anspruch 4 oder 5, mit einem ersten elektrischen Isolationselement (212a), das an dem ersten Leiterplattenelement (111₁) und dem zweiten Leiterplattenelement (111₂) zugewandt angeordnet ist; und mit einem zweiten elektrischen Isolationselement (212b), das an dem zweiten Leiterplattenelement (111₂) und dem ersten Leiterplattenelement (111₁) zugewandt angeordnet ist.

7. Optokoppler gemäß einem der Ansprüche 4 bis 6, bei dem die Leiterplattenstruktur eine Aussparung (211) entlang einer Strecke zwischen der ersten optischen Vorrichtung (12; 120) und der zweiten optischen Vorrichtung (18; 121) umfasst, die eine Ausdehnung senkrecht zu der Strecke aufweist, um eine Kriechstromwegverlängerung bereitzustellen.

8. Optokoppler gemäß einem der Ansprüche 4 bis 7, bei dem die Haltestruktur (28; 111; 610) ein elektrisch isolierendes Isolationselement (212) umfasst, das entlang einer Stecke zwischen der ersten optischen Vorrichtung (12; 120) und der zweiten optischen Vorrichtung (18; 121) zumindest teilwiese angeordnet ist;
wobei das Isolationselement (212) in einem Kontaktbereich in eine Aussparung der Haltestruktur (111) eingepresst ist und in dem Kontaktbereich Erhebungen oder Vertiefungen bezüglich der Haltestruktur (111) aufweist, die ausgebildet sind, um eine Klemmkraft gegenüber der Haltestruktur bereitzustellen.

9. Optokoppler gemäß einem der vorangehenden Ansprüche, umfassend eine Kriechstromwegverlängerung, die ausgebildet ist, um eine Weglänge eines Kriechstroms (230) verglichen mit einem direkten Pfad und zwischen der ersten optischen Vorrichtung (12; 120) und der zweiten optischen Vorrichtung (18; 121) zu verlängern.

10. Optokoppler gemäß einem der vorangehenden Ansprüche, bei dem die erste optische Vorrichtung (12; 120) und die zweite optische Vorrichtung (18; 121) ein erstes Übertragerpaar bilden und eine Mehrzahl von für einen zeitlich und/oder räumlich parallelen Betrieb eingerichtete Übertragerpaaren an der Haltestruktur (28; 111; 610) angeordnet ist;
wobei der Optokoppler ausgebildet ist, um basierend auf voneinander verschiedenen Sensorelementen Sensordaten für voneinander verschiedene Sensorkanäle mit voneinander verschiedenen Übertragerpaaren zu übertragen.

11. Optokoppler gemäß einem der Ansprüche 1 bis 10, wobei der Optokoppler für einen Betrieb in einer Optikanordnung eingerichtet ist, wobei sich die Optikanordnung parallel zu einer Optikebene erstreckt, wobei die erste optische Vorrichtung (12; 120) und die zweite optische Vorrichtung (18; 121) in einer übereinstimmenden Ebene parallel zu der Optikebene angeordnet sind; oder
wobei der Optokoppler für einen Betrieb in einer Optikanordnung eingerichtet ist, wobei sich die Optikanordnung parallel zu einer Optikebene erstreckt, wobei die erste optische Vorrichtung (12; 120) und die zweite optische Vorrichtung (18; 121) in unterschiedlichen Ebenen gegenüberliegend angeordnet sind; oder
wobei ein optischer Transmitter der ersten optischen Vorrichtung (12; 120) und ein optischer Empfänger der zweiten optischen Vorrichtung (18; 121) in einer radialen Anordnung positioniert sind und der optische Transmitter den optischen Empfänger an der Ausgangsapertur umschließt; oder der optische Empfänger den optischen Transmitter an der Ausgangsapertur umschließt.

12. Optokoppler gemäß einem der vorangehenden Ansprüche, der als integrierte Vorrichtung gebildet oder Teil eines integrierten Systems ist.

13. Optokoppler gemäß einem der vorangehenden Ansprüche, bei dem die erste optische Vorrichtung (12; 120) ausgebildet ist, um das optisch-faserlose Signal (16) im Wesentlichen parallel zu einer Montageoberfläche auszusenden, an welcher die erste optische Vorrichtung (12; 120) angeordnet ist; oder bei dem die erste optische Vorrichtung (12; 120) ausgebildet ist, um das optisch-faserlose Signal (16) im Wesentlichen senkrecht zu der Montageoberfläche auszusenden.

14. System mit:
einem Optokoppler gemäß einem der vorangehenden Ansprüche; und
einer Datenquelle (130), die mit der ersten optischen Vorrichtung (12; 120) gekoppelt ist, um vermittels des optisch-faserlosen Signals (16) Daten an die zweite optische Vorrichtung (18; 121) zu senden; und
einem Datenempfänger (131), der ausgebildet ist, um die Daten von der zweiten optischen Vorrichtung (18; 121) zu empfangen.

15. System gemäß Anspruch 14, bei dem die Datenquelle (130) mit einer Hochpotentialseite des Systems und der Datenempfänger (131) mit einer Niederpotentialseite des Systems elektrisch gekoppelt ist.
